# EUROPEAN PATENT APPLICATION

(11) **EP 1 962 429 A1**
(43) Date of publication of application: **27.08.2008**
(21) Application number: 08101615.6
(22) Date of filing: 14.02.2008
(51) Int. Cl.: H03M 7/30

(54) **Method and apparatus for compressing data**

(30) Priority: 21.02.2007 KR 20070017506
(71) Applicant: Samsung Electronics Co., Ltd., Suwon-si, Gyeonggi-do 442-742 (KR)
(72) Inventor: JUNG, Ji Won, Suwon-si, Gyeonggi-do (KR)
(74) Representative: Walaski, Jan Filip

(57) **Abstract**

An apparatus and method for compressing data are described. The apparatus can properly select any one of two compression codecs (i.e., the lossless codec and the lossy codec) according to compression capacities, compress the print data using the selected compression codec, and store the compressed data in the memory, such that an overall compression rate is decreased and the memory efficiency increases. Although the data is compressed by the lossy codec and a low compression rate is provided, the user may not notice the deterioration of the image quality. The method for compressing data includes compressing print data using a first codec; storing the compressed data in a memory; monitoring a compression capacity of the stored data; stopping the compression using the first codec based on the compression capacity, and re-compressing the print data using a second codec; and storing the re-compressed data in the memory.

## Description

The present invention relates to a data file compression apparatus and a method thereof, and more particularly to an apparatus and method for compressing data to enhance a printing quality of an image printed by a printing device.

File compression or data compression used in an image forming apparatus involves encoding and decoding data using a smaller number of bits than the initial data, so as to reduce the size of a data memory area. Data compression schemes are generally classified into lossless compression schemes and lossy compression schemes.

According to lossless compression, when compressed data is decompressed, the bits of the uncompressed data are identical to the bits of initial data created before the data compression. Lossless compression can compress the size of a file to 40% of the original file size.

According to lossy compression, when the compressed data is decompressed, some data is lost, such that the uncompressed data is different from initial data created before the data compression. Lossy compression can compress the size of a file to 5% of an original file size.

Due to the above-mentioned characteristics, lossless compression is generally used to compress important data (e.g., text, code data, or numerical data). Lossy compression is generally used to compress multimedia data (e.g., video and audio data).

If the image forming apparatus performs lossless compression on the image, the compression efficiency is decreased and the image quality increases. If the image forming apparatus performs lossy compression, the compression efficiency increases and the image quality decreases.

If the image forming apparatus receives data to be printed from a host computer or an external device, the image forming apparatus compresses data using a coder/decoder (codec), which can be software or hardware, included in the image forming apparatus, and stores the compressed data in a memory, so as to increase data processing efficiency. In this case, lossless compression is used as the compression method. Due to the characteristics of lossless compression, compression efficiency decreases and the image quality increases. As a result, the image forming apparatus requires a large-capacity memory.

In order to solve the above-mentioned problems, if the compression capacity of data is higher than a capacity of the memory, a conventional image forming apparatus lowers the printing quality of the image to be printed, and prints the image at the low printing quality. The low printing quality is, for instance, applied in order to increase the speed of printing and therefore enable the amount of data stored in the memory to be reduced more quickly.

However, the above-mentioned conventional image forming apparatus compresses data using a lossless codec, such that the compression rate is low and image quality is high, resulting in an increased memory requirement. If the capacity of the compression data is higher than a predetermined capacity, the conventional image forming apparatus may unavoidably print the compressed data at a low image quality.

Aspects of the present invention provide an apparatus and method for compressing data, if compression capacity is higher than a predetermined capacity while data to be printed is compressed according to a lossless compression method and is then stored in a memory, which re-compresses the data using another compression method, such that image quality can be increased.

According to an aspect of the present invention, a method of compressing data is provided. The method comprises compressing print data using a first codec; storing the compressed data in a memory; monitoring a compression capacity of the stored data; stopping the compression using the first codec based on the compression capacity, and re-compressing the print data using a second codec; and storing the re-compressed data in the memory.

According to another aspect of the present invention, an apparatus to compress data is provided. The apparatus comprises a first codec to compress print data; a second codec to compressing the print data; a memory to store data compressed by the first codec and the second codec; and a compression capacity monitoring unit to monitor a compression capacity of the data stored in the memory, stop the compression using the first codec based on the monitored compression capacity, to re-compress the print data using the second codec, and to re-store the re-compressed data in the memory.

In addition to the example embodiments and aspects as described above, further aspects and embodiments will be apparent by reference to the drawings and by study of the following descriptions.

Embodiments of the invention will now be described, by way of example, with reference to the accompanying drawings, in which:
Figure 1 is a block diagram illustrating a data compression apparatus according to an example embodiment of the present invention;
Figure 2 is a block diagram illustrating a lossless codec unit shown in Figure 1; and
Figure 3 is a flow chart illustrating a data compression process according to an example embodiment of the present invention.

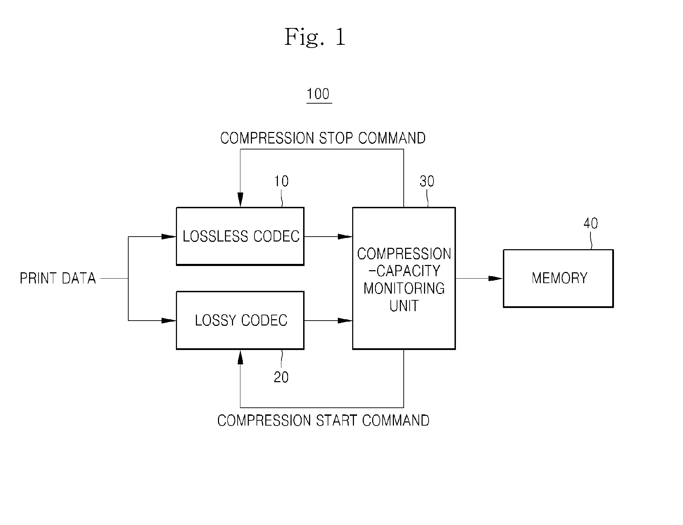

Figure 1 is a block diagram illustrating a data compression apparatus 100 according to an example embodiment of the present invention. The data compression apparatus 100 includes a lossless codec 10, a lossy codec 20, a compression capacity monitoring unit 30, and a memory 40. As shown in Figure 1, the lossless codec 10 is connected in parallel to the lossy codec 20. The compression capacity monitoring unit 30 is connected to the input terminal of the memory 40. According to other aspects of the invention, the data compression apparatus 100 may include additional and/or different units. Similarly, the functionality of two or more of the above units may be combined into a single component.

The compression capacity monitoring unit 30 monitors the compression capacity stored in the memory 40, in particular the amount of memory space occupied by compressed data. If the compression capacity, or occupied memory space, is higher than a predetermined capacity, the compression capacity monitoring unit 30 outputs a specific command to the lossless codec 10 to interrupt the compression operation of the lossless codec 10, and outputs another command to the lossy codec 20 to initiate a compression operation using the lossy codec 20.

Generally, data is initially compressed according to the lossless compression, and is then stored in the memory 40. However, according to other aspects of the invention, data may be initially compressed using lossy compression.

If the magnitude of the compressed data is higher than the capacity of the memory 40, the compression-capacity monitoring unit 30 monitors the capacity of the compressed data stored in the memory in real time. If the capacity of the compressed data is higher than a predetermined capacity, the lossless compression based on the lossless codec 10 is interrupted, the lossy codec 20 starts lossy compression on the initial data, and the lossless-compressed data is, for instance, overwritten by the lossly-compressed data. In this case, the data is compressed using different codecs. The categories of codecs used may be recorded in a header part of the compressed data based on a decoding time.

Alternatively, in other embodiments, in response to the amount of memory space used to store compression data exceeding a predetermined value, further print data may be compressed using the lossy codec 20 and stored in the memory 40, without over-writing compressed data already stored in the memory 40.

Any one of two compression codecs may be selected according to the compression capacities, and the selected compression codec is stored in the memory, such that an overall compression rate is decreased and memory efficiency increases, resulting in increased printing quality of the image forming apparatus.

As described above, if the image forming apparatus prints data using the lossless compression method, the compression efficiency is decreased and the image quality increases due to the characteristics of the lossless compression method. As a result, if the compression capacity is higher than a predetermined capacity, the image forming apparatus may unavoidably print data at a low printing quality.

In order to solve the above-mentioned problems, if the compression capacity is higher than a predetermined capacity, the image forming apparatus re-compresses the data using the lossy codec 20. As a result, the compression capacity is lowered, the memory efficiency increases, and the printing quality of the image forming apparatus also increases. Although the data is compressed according to the lossy codec, the user may not notice the reduced quality of the image quality if the data is compressed at a low compression rate.

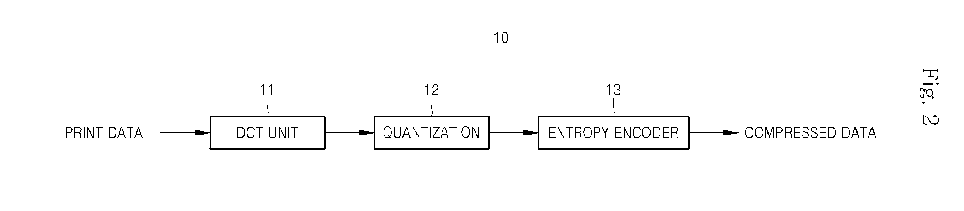

Figure 2 is a block diagram illustrating a lossless codec shown in Figure 1. The lossless codec 10 sequentially performs a DCT (Discrete Cosine Transform) process, a quantization process, an entropy encoding process, such that the print data is compressed. The DCT unit 11 performs the DCT process on pixels of the print data in block units. The quantization unit 12 performs the quantization process on the DCT coefficient acquired from the DCT unit 11, expresses some representative values associated with the quantized result, and outputs quantization data. The entropy encoder 13 performs the entropy encoding process on the quantization data acquired from the quantization unit 12, and generates compressed data.

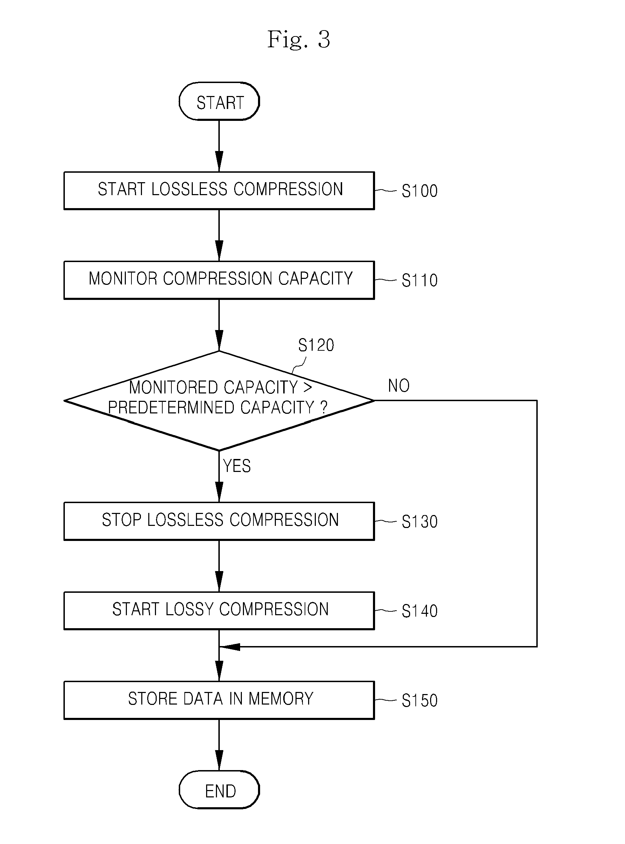

Figure 3 is a flow chart illustrating a data compression process according to an example embodiment of the present invention. The lossless codec 10 compresses data according to the lossless compression method at block S100. The compressed data is stored in the memory 40.

The compression-capacity monitoring unit 30 monitors the compression capacity stored in the memory 40 at block S110. The compression-capacity monitoring unit 30 compares the monitored compression capacity with a predetermined capacity, and determines whether the monitored compression capacity is higher than the predetermined capacity at block S120. If the monitored compression capacity is higher than the predetermined capacity, the compression-capacity monitoring unit 30 stops operations of the lossless codec 10 at block S130, interrupting the lossless compression. The compression-capacity monitoring unit 30 compresses data using the lossy codec 20 at block S140.

The lossy-compressed data is stored in the memory 40 at block S150. The compressed data stored in the memory is printed onto a printable medium by the image forming apparatus. The memory efficiency and the printing quality can be increased by lowering the compression capacity. If compression scheme having a high compression rate is not employed by the lossy codec 20, the user may not notice the reduced image quality.

As is apparent from the above description, aspects of the present invention may select any one of two compression codecs (i.e., the lossless codec 10 and the lossy codec 20) according to compression capacities, compress the print data using the selected compression codec, and store the compressed data in the memory, such that an overall compression rate is decreased whereas the memory efficiency increases. Although the data is compressed by the lossy codec 20 and a low compression rate is provided, the user may not notice the reduced image quality.

In addition, the present invention can also be embodied as computer readable codes on a computer readable recording medium. The computer readable recording medium is any data storage device that can store data which can be thereafter read by a computer system. Examples of the computer readable recording medium also include read-only memory (ROM), random-access memory (RAM), DVDs, CDs, magnetic tapes, floppy disks, optical data storage devices, and carrier waves (such as data transmission through the Internet). The computer readable recording medium can also be distributed over network coupled computer systems so that the computer readable code is stored and executed in a distributed fashion. Also, functional programs, codes, and code segments for accomplishing the present invention can be easily construed by programmers skilled in the art to which the present invention pertains.

While there have been illustrated and described what are considered to be example embodiments of the present invention, it will be understood by those skilled in the art and as technology develops that various changes and modifications, may be made, and equivalents may be substituted for elements thereof without departing from the true scope of the present invention. Many modifications, permutations, additions and sub-combinations may be made to adapt the teachings of the present invention to a particular situation without departing from the scope thereof as defined by the appended claims.

For example, although the data compression apparatus has been described in conjunction with an image forming apparatus, the data compression apparatus may be used with any device using compression schemes. Similarly, the compression capacity monitoring unit may be incorporated into a controller that controls the operation of the image forming apparatus (or other device). In addition, although two codecs have been described, a plurality of codecs may be used. Accordingly, it is intended, therefore, that the present invention not be limited to the various example embodiments disclosed, but that the present invention includes all embodiments falling within the scope of the appended claims.

## Claims

1. A method of compressing data, comprising:
compressing data according to a first data compression scheme having a first data compression rate;
storing the compressed data in a memory;
determining the amount of memory occupied by the compressed data; and
in response to the determined amount of memory exceeding a predetermined value, switching from compressing data according to the first compression scheme to compressing data according to a second data compression scheme, the second data compression scheme having a second data compression rate greater than the first data compression rate.

2. A method according to claim 1, wherein:
the data comprises print data;
compressing data according to a first data compression scheme comprises compressing data using a first codec;
determining the amount of memory occupied by the compressed data comprises monitoring a compression capacity of stored data; and
performing further data compression according to a second data compression scheme comprises stopping the compression using the first codec based on the determined amount of memory, and re-compressing the print data using a second codec; the method further comprising:
storing re-compressed data in the memory.

3. The method according to claim 2, further comprising:
stopping the compression based on the first codec if the monitored compression capacity is equal to or higher than a predetermined capacity.

4. The method according to claim 3, wherein the predetermined capacity is a memory capacity.

5. The method according to claim 2, 3 or 4, wherein the first codec is a lossless codec.

6. The method according to any one of claims 2 to 5, wherein the second codec is a lossy codec.

7. The method according to any one of claims 2 to 6, wherein the re-compressed data is stored in the memory by overwriting the compressed data.

8. Apparatus for compressing data, comprising:
means for compressing data according to a first data compression scheme having a first data compression rate and for compressing data according to a second data compression scheme having a second data compression rate;
a memory for storing compressed data;
means for determining the amount of memory occupied by compressed data; and
means for switching from compression according to the first data compression scheme to compression according to the second data compression scheme in response to the determined amount of memory exceeding a predetermined value.

9. An apparatus according to claim 8, wherein:
the data comprises print data;
the data compressing means comprises a first codec for compressing the print data according to the first data compression scheme and a second codec for compressing the print data according to the second data compression scheme; and
the determining means comprises a compression-capacity monitoring unit for monitoring a compression capacity of the data stored in the memory, for stopping the compression based on the first codec based on the monitored compression capacity, for re-compressing the print data using the second codec, and for storing the re-compressed data in the memory.

10. The apparatus according to claim 9, wherein the compression-capacity monitoring unit is arranged to compare the monitored compression capacity with a predetermined capacity, and to stop the compression based on the first codec if the monitored compression capacity is equal to or greater than the predetermined capacity.

11. The apparatus according to claim 10, wherein the predetermined capacity is a capacity of the memory.

12. The apparatus according to claim 9, 10 or 11, wherein the first codec is a lossless codec.

13. The apparatus according to any one of claims 8 to 12, wherein the second codec is a lossy codec.

14. The apparatus according to any one of claims 9 to 13, wherein the compression capacity monitoring unit is arranged to re-store the re-compressed data in the memory by overwriting the compressed data.

15. An apparatus according to any one of claims 8 to 14, further comprising a printing unit to form an image corresponding to the compressed data onto a printable medium.

16. A computer program which, when executed by a processor, causes the method of any one of claims 1 to 7 to be performed.
